(19) Europäisches Patentamt
European Patent Office
Office européen des brevets

(11) **EP 0 814 342 B1**

(12) **EUROPEAN PATENT SPECIFICATION**

(45) Date of publication and mention
of the grant of the patent:
**14.11.2007 Bulletin 2007/46**

(51) Int Cl.:
***G01R 33/12*** *(2006.01)*

(21) Application number: **97401424.3**

(22) Date of filing: **19.06.1997**

(54) **Detecting equipment for minute magnetic substance contained in long object to be inspected**

Detektionsgerät für magnetische Substanze in minimaler Menge in untersuchten langen Gegenständen

Dispositif de détection pour des substances magnétiques à quantité minuscule dans un objet long à contrôler

(84) Designated Contracting States:
**DE FR GB IT NL**

(30) Priority: **21.06.1996 JP 18117196**

(43) Date of publication of application:
**29.12.1997 Bulletin 1997/52**

(73) Proprietor: **SUMITOMO ELECTRIC INDUSTRIES, LIMITED**
**Osaka 541 (JP)**

(72) Inventors:
• **Nagaishi, Tatsuoki**
**1-1 Koyakita 1-chome,**
**Itami-shi,**
**Hyogo (JP)**
• **Kugai, Hirokazu**
**1-1 Koyakita 1-chome,**
**Itami-shi,**
**Hyogo (JP)**
• **Itozaki, Hideo**
**1-1 Koyakita 1-chome,**
**Itami-shi,**
**Hyogo (JP)**

(74) Representative: **Ballot, Paul Denis Jacques**
**Cabinet Ballot**
**122, rue Edouard Vaillant**
**92593 Levallois-Perret Cedex (FR)**

(56) References cited:
**EP-A- 0 634 652**      **US-A- 3 854 085**
**US-A- 3 976 934**

• **COCHRAN A ET AL: "FIRST-GENERATION SQUID-BASED NONDESTRUCTIVE TESTING SYSTEM" IEE PROCEEDINGS A. PHYSICAL SCIENCE, MEASUREMENT & INSTRUMENTATION, MANAGEMENT & EDUCATION, vol. 140, no. 2 PART A, 1 March 1993, pages 113-120, XP000361886**
• **COCHRAN A: "SQUIDS FOR NDT: THE TECHNOLOGY AND ITS CAPABILITIES" BRITISH JOURNAL OF NON DESTRUCTIVE TESTING, vol. 35, no. 4, 1 April 1993, pages 173-182, XP000363165**

**Description**

**Background of the Invention**

Field of The Invention

The present invention relates to a detecting equipment of magnetic minute substance. More specifically, the detecting equipment of the present invention can detect continually in high sensitivity entity of fine particle without destroying an object to be inspected having shape of a wire or a lod.

Description of Related Art

A foreign matter contained in a long material is possible cause of serious trouble even if the foreign matter is very small. For example, Cu is to be a wire material as an electric conductor. At some time, it is thinned to less than 100 $\mu$m in diameter. However, Cu runs out on elongated process, when a foreign matter of less than 10 $\mu$m is contained in the Cu material. For other example, when a foreign matter of less than 10 $\mu$m exists in its isolation coating, proof pressure of a cable line conveying power in high voltage of 500 kV extremely deteriorates.

As a method to detect a foreign matter in a material using electromagnetic induction is known. However, this method can detect a foreign matter more than approximately 100 $\mu$m. Accordingly, a small foreign matter less than 100 $\mu$m cannot be detected. Some new method that can detect smaller foreign matter is required.

For this technical subject, the applicant has filed a patent application concerning to a new detecting equipment already as a US. Patent Application No.08/273,433.

This equipment detects a drift of a magnetic field including an object to be inspected caused of existence of a foreign matter. This equipment comprises a SQUID(Superconducting QUantum Interference Device) as a magnetic sensor having very high sensitivity. Accordingly, output signal of the SQUID is affected by a drift of the environmental magnetic field. Then, the circumference of the SQUID and the object to be inspected is surrounded with a magnetic shield container and detection of magnetic substance is done inside of the magnetic shield container. A magnetic shield container is made of a permalloy for example.

However, when an object to be inspected is a very long object like a wire, the object to be inspected cannot be accommodated in a magnetic shield container. Then, the detection is enforced while carrying in and out of the object to be inspected . In other words, during the detection, object to be inspected is charge from one end of the magnetic shield container and carried out from the other end of the magnetic shield container simultaneously. Accordingly, a pair of opening needs to be made for the magnetic shield container. The object to be inspected is carried in and out through the openings.

However, immersion of outside magnetic field must be prevented invading through the openings. In said patent application, a magnetic shield container having special shape is used for inspecting a long object to be inspected and immersion of outside magnetic field is prevented by the shape of the container.

But, it is difficult to produce the magnetic shield container having a complicated shape. At the same time, to handle the container actually is difficult too, because complicated shape requires complicated operation to insert a long material.

**Summary of the Invention.**

A purpose of the present invention is to provide a detecting equipment having high detectivity and which is easy to use.

The detecting equipment of the present invention comprises a magnetic field generation means and a magnetic sensor.

The magnetic field generation means generates a magnetic field and an object to be inspected runs inside of the magnetic field along its overall length direction . Then the object to be inspected is magnetized.

The magnetic sensor comprises a SQUID as a part of a magnetic sensor. Magnetic sensor is arranged in neighborhood of traveling path of the object to be inspected and more later than the magnetic field generation means. When magnetic substance is contained in the object to be inspected, magnetic field changes. The magnetic sensor detects the change of the magnetic field by the SQUID.

In the equipment of the present invention, the magnetic field generation means generates a magnetic field that is right angle to the traveling direction of the object to be inspected. Accordingly, the object to be inspected is magnetized in right angle to traveling direction. On the other hand, sensitivity of the magnetic sensor is highest in a specific direction.

When magnetic sensor consists of individual SQUID only, the direction that detectivity becomes highest is the direction that is right angle to formation surface of the SQUID. When magnetic sensor comprises a SQUID and a flux transformer, the direction is the direction that is right angle to the plane including the pickup coil of the flux transformer.

These two configuration is major characteristics of the present invention. In the detecting equipment of the present invention, the object to be inspected is magnetized before inspected by the magnetic sensor. Accordingly, a magnetic minute substance in a object to be inspected is magnetized in specified direction too. As a result, requirement to the magnetic shield container is moderated.

A typical application of the detecting equipment of the present invention is check in manufacturing process of wire-rod material. In this field, the following fact is understood that most of the foreign matter in an object is fine iron particle. In detecting equipment of the present invention, at first, an object to be inspected runs inside of a magnetic field generated by the magnetic field generation means and next passes neighborhood of the magnetic sensor. A magnetic substance contained in the object to be inspected is magnetized by the magnetic field corresponding to each peculiar characteristic magnetic susceptibility. When a magnetized foreign matter passes in a magnetic field, the magnetic field occurs a draft. And, the magnetic sensor detects a drift of the magnetic field. This is the principle of operation of the equipment of the present invention.

Thus, the equipment of the present invention can detect extremely magnetic minute substance in high sensitivity. According to a desirable embodiment of the present invention, detection by SQUID is carried out in the magnetic shield container. Magnetic shield container defined a range covered from intercepting of outer magnetic field. The inner magnetic field is not disturbed by drift of the environment magnetic field. The magnetic shield container can be made of Permalloy for example.

By the way, when an object to be inspected is a long material, an opening for object to be inspected to pass is established with the magnetic shield container. Furthermore, when the long material is running in succession while inspected, inside diameter of the openings must be larger than the diameter of the object to be inspected. However, when inside diameter of the openings are so large, the outside magnetic field invades into the container through the openings. This is never desirable of course.

For this matter, the equipment of the present invention comprises a characteristic structure. In the detecting equipment of the present invention, an object to be inspected is magnetized in peculiar direction before the detecting by the magnetic sensor. Namely, magnetization is done in the magnetic field that is right angle to traveling direction of the object to be inspected. Accordingly, the magnetic sensor detects a drift of the magnetic field that is right angle to the traveling direction of the object to be inspected. On the other hand, a magnetic field invaded from the openings are the magnetic field that is parallel to the traveling direction of the object to be inspected. Accordingly, affect of outside magnetic field can be eliminated effectively by a magnetic shield container of simple configuration.

According to another embodiment of the present invention, the equipment of the present invention comprises several magnetic sensors. Each magnetic sensor is located each arranged location so that spacing from object to be inspected to each magnetic sensor is different mutually. Each magnetic sensor exhibit an unique output. Each output of the magnetic sensor is correspond to constant magnetic field and to spacing between the object to be inspected and each magnetic sensor. Accordingly, the true drift can be detected from difference between outputs of the magnetic sensors. Thus the affect of the outside magnetic field can be eliminated.

Some noise to be generated by the SQUID itself exists furthermore, and the output of the SQUID contains this type of noise, too. It is desirable to use a filter for elimination of the noise. A filter is inserted between the signal processing circuit and the output device. The filter lets pass only signal with specified frequency bandwidth.

According to other embodiment, the SQUID as a magnetic sensor can be made of an oxide superconducting thin film. Because oxide superconducting thin film has a high superconducting critical temperature, it becomes a superconductor by cooling off with a liquid nitrogen. Liquid nitrogen is inexpensive and feeding of liquid nitrogen is stable. Accordingly, running cost of the magnetic sensor with a SQUID made of a superconducting thin film becomes low and manipulation of SQUID in operation is easy.

As described in detail mentioned above, the present invention realizes the following benefit. This equipment can detect extremely minute magnetic substance of minute dozens of $\mu$m dimension from an object to be inspected running in succession. Accordingly, gross quantity check in manufacturing process of long material can be enforced.

The present invention will be understood furthermore by following descriptions referring figures.

## Brief Description of Figures

Figure 1 is a figure of squint to show basic framing of the detecting equipment of the present invention.

Figure 2 is a part dap figure showing concrete construction of the detecting equipment of the present invention.

Figure 3 is a part dap figure showing construction of usable magnetic sensor in the detecting equipment of the present invention.

Figure 4 is a graph which resultant inspected using the detecting equipment shown in figure 2.

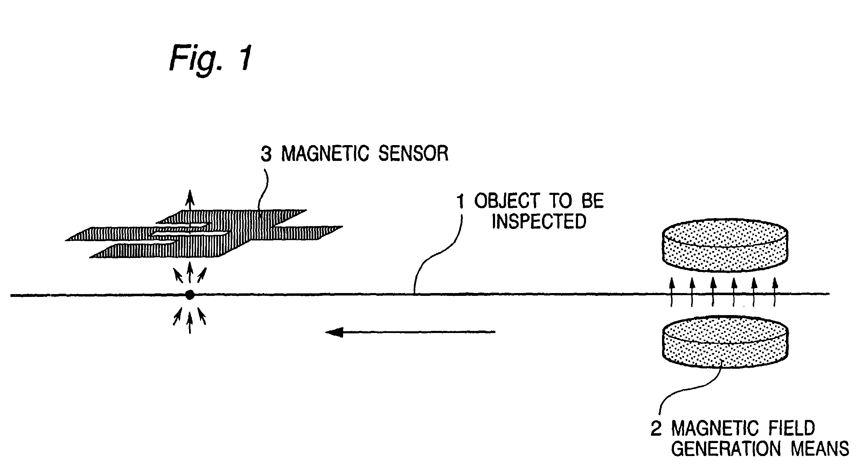

Principle of operation of the detecting equipment of the present invention is explained referring figure 1.

Object to be inspected 1 is long material and travels along a constant path. The detecting equipment possesses a magnetic field generation means 2 and a magnetic sensor 3 arranged along object to be inspected 1. The magnetic field generation means 2 is generated the constant magnetic field which is right angle to the traveling direction of the object to be inspected 1.

At first, the object to be inspected 1 passes the inside of the magnetic field. When magnetic substance is contained in the object to be inspected 1, the magnetic substance is magnetized according to its magnetic susceptibility while passing inside of the magnetic field. In next, the object to be inspected 1 passes near to the magnetic sensor 3 comprising a SQUID. SQUID is formed on a plane which is right angle to the magnetic field.

When no magnetic substance is contained in the object to be inspected 1, the SQUID outputs constant signal corresponding to magnetic susceptibility of the object to be inspected 1. When magnetic substance is contained in the object to be inspected 1, the magnetic field is peculiar changed by the magnetized substance and the output voltage of the SQUID changes. SQUID is been very sensitive to detect a drift of a magnetic field. Accordingly, magnetic minute substance can be detected.

### Description of Preferred Embodiment

Embodiment 1

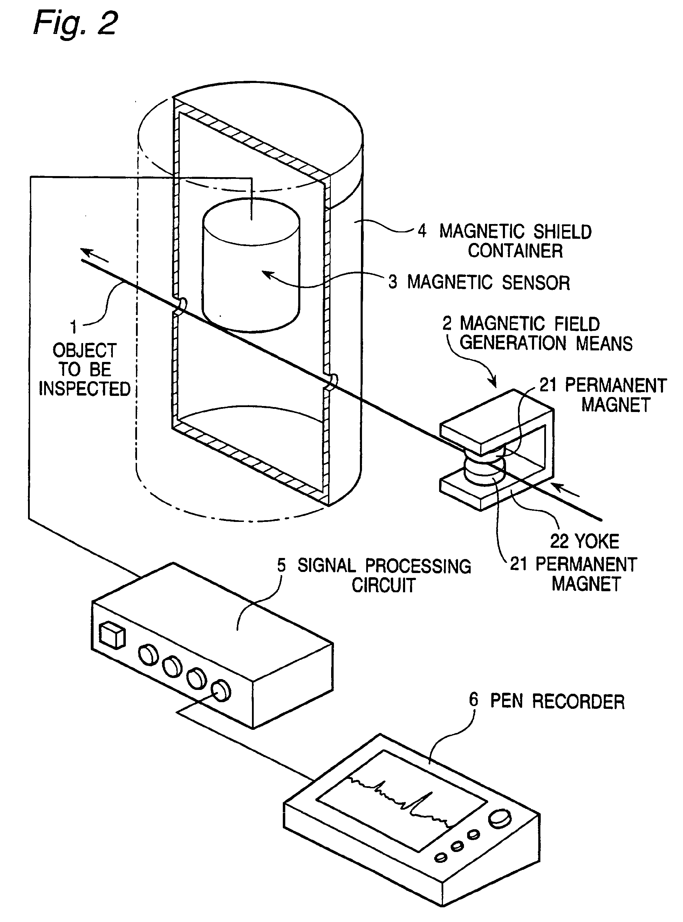

Figure 2 is a figure of squint to show one of a concrete framing of the detecting equipment of the present invention. On the figure 1, equal reference number was added to each element that is a common element in the figure 1.

This detecting equipment comprises a magnetic field generation means 2, a magnetic sensor 3 and a magnetic shield container 4.

The magnetic field generation means 2 comprises a pair of permanent magnets 21 and a yoke 22. The yoke 22 is put together permanent magnet 21 magnetically. The magnetic field toward one permanent magnet from another permanent magnet is generated.

The magnetic sensor consists of a heat insulation container 34 and a SQUID that is arranged on the base of the heat insulation container horizontally. The heat insulation container 34 is met with a cooling medium. The SQUID is placed parallel to the traveling direction of the object to be inspected. At the same time, the SQUID is arranged in right angle to the magnetic field generated by the magnetic field generation means, because the magnetic flux running through the SQUID becomes maximum. The SQUID functions as a magnetic sensor which has high sensitivity.

The magnetic shield container 4 wraps up magnetic sensor 3 and a part of the object to be inspected that is traveling near by the magnetic sensor 3. The magnetic shield container 4 eliminates jamming by the environmental magnetic field to the magnetic sensor 3.

The output signal of the magnetic sensor 3 is communicated to a signal processing equipment 5 that is based on a FLL(flux locked loop) circuit. Furthermore, a pen recorder 6 as a recording device is mounted to the signal processing equipment 5.

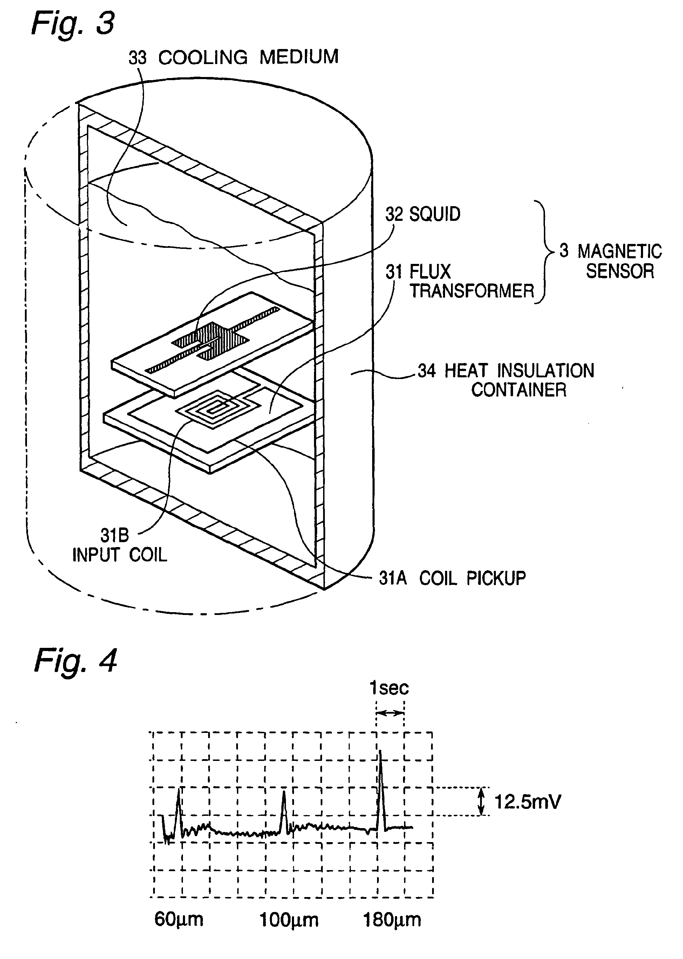

One of concrete construction of the magnetic sensor can be use as the magnetic sensor 3 is shown in the figure 3.

By the way, a SQUID without other attached device functions as a magnetic sensor. However, sensitivity of the SQUID as a magnetic sensor can be improved by jointly using with a flux transformer.

The magnetic sensor 3 shown in the figure 3 comprises a SQUID 32 and a flux transformer 31. The SQUID 32 and the flux transformer 31 are each formed of a superconducting thin films on a substrates. In flux transformer 31, a pickup coil 31A and an input coil 31B are connected each other. The pickup coil 31 A has a little winding numbers. On the contrary, the input coil 31 B has much winding numbers. Center of the input coil 31 B and center of the SQUID 32 accord with each other. Furthermore, the flux transformer 31 and SQUID 32 is taken into the heat insulation container 34. The heat insulation container 34 is met with a cooling medium 33 for example liquid nitrogen.

In the figure 3, SQUID 32 and flux transformer 31 are drawn separately. However, actually, the SQUID and the flux transformer are cohered to each other, while the superconducting thin film which forms the SQUID 32 is on lower surface of substrate. At the same time, it is preferred to insert an isolation layer between the SQUID 32 and the flux transformer 31 not to make a short-circuit.

Furthermore, actually, the input coil 31B and SQUID 32 is exaggerated in figure 3. But, their abbreviations are almost same dimension. On the other hand, length of the input coil 31 B on the bank is around 1/8 of overall length of the pickup coil 31 A on the bank. In figure 3, delineation is omitted about individual electric wiring.

Magnetic sensor may be exchange to a gradiometer. So called gradiometer comprises a pair of electric coil which has opposite direction each other. Variation of magnetic field changing in the whole like an environment magnetic field is denied. Accordingly, there is some case that the magnetic shield container can be omitted.

The detecting equipment mentioned above has been made actually.

The SQUID and the flux transformer made of $Y_1Ba_2Cu_3O_{7-x}$ thin film deposited on $SrTiO_3$ substrate and

patterned. The weak link department of SQUID made pattern breadth of thin film narrow.

Furthermore, difference in grade that has bearing height of 1600 Å was formed on the substrate before depositing thin film. Artificial grain boundary in the thin film is formed at a place of the difference in grade. The artificial grain boundary contributed to formation of a weak link, too.

The magnetic field generation means was made with permanent magnets and arranged so that the object to be inspected passed in the magnetic field inside of approximately 0.1 tesla. Magnetic field generated was right angle to the traveling direction of the object to be inspected.

Furthermore, the input coil of flux transformer arranged on the plane that was right angle to the magnetic flux generated. The input coil was arranged 15 mm apart from the pass of the object to be inspected. It is prefer to sensitivity of the magnetic sensor that the spacing between the object to be inspected and the magnetic. But, actually, by die thickness of the insulation container 34 , the spacing was forced to be 15 mm. Magnetic shield container which is formed a pair of openings to pass the object to be inspected was made of permalloy. The openings have diameter of 20 mm and are simple bore with no additional thing.

We confirmed actuating of the detecting equipment mentioned above. Polyester line having a diameter of 0.5 mm and was prepared. It was confirmed beforehand that the polyester line contains no foreign matter. At the same time, iron powder which has a diameter of 60 $\mu$m, 100 $\mu$m or 180 $\mu$m was prepared. The polyester line was sticked the iron powder, and became an object to be inspected. The polyester line was inspected by the equipment while letting run by 10 m per second.

The output of the signal processing equipment 5 was introduced into the pen recorder 6 through a filter. The filter was a lowpass filter having cut-off frequency of 10 Hz. The pen recorder 6 recorded measurement resultant which is described in figure 4.

We could confirm that the iron powder having 60 $\mu$m of particle size has been detected.

Next, we confirm effect by a direction of the magnetic field about disposition of the magnet sensor. At first, components same as the detecting equipment mentioned above were prepared. Another detecting equipment for comparing was assembled with this components. However, in the detecting equipment for comparing, the angle of permanent magnets of the magnetic field generation means were different. The angle of the permanent magnets varies 90 degree from the angle of the magnets in the equipment of the present invention. Accordingly, the direction of magnetic field becomes parallel to the formation surface of the flux transformer and the SQUID.

As a sample, nylon line having a diameter of 0.5 mm was prepared. It was confirmed beforehand that the Nylon line itself includes no magnetic substance. Iron powder having a particle size of 500 $\mu$m was sticked to the nylon line.

The nylon line was inspected by the detecting equipment mentioned above. At the same time, the same sample was inspected by the equipment of the present invention. As a result, a sensitivity of the present invention was high approximately 3 times to the equipment for comparing. In other words, the variation of output signal of the magnetic sensor was 3 times as much.

Embodiment 2

The detecting equipment of this embodiment is different from the equipment of the first embodiment in period to have two magnetic sensors.

Principle of operation of each magnetic sensor is equal in case of the first embodiment. And, each magnetic sensor has the same construction as the magnetic sensor shown in figure 3, too.

The first magnetic sensor is arranged on the same location as the first embodiment. Namely, the first magnetic sensor is located the position that was 15 mm away from the object to be inspected. On the contrary, the second magnetic sensor is located 100 mm more distant from the object to be inspected than the first magnetic sensor. And the second magnetic sensor is arranged parallel to the first magnetic sensor.

Output of the first magnetic sensor and output of the second magnetic sensor are each output through FLL circuits. The signal processing circuit comprises an operational amplifier receiving outputs of two FLL circuit at its input end. The operational amplifier outputs difference between the outputs of the two FLL circuit. The output signal of the operational amplifier is handled with signal processing circuit of the first embodiment in the same way as an output of a magnetic sensor. Such construction can let reduce affect of the earth magnetic field and background magnetic field. There is some case that the use of the magnetic shield container can be omitted.

Even detecting equipment having such construction was able to detect magnetic substance of minimum 60 $\mu$m actually.

In the detecting equipment having the construction mentioned above, a signal corresponding to existence of a foreign matter is provided from the output of the first magnetic sensor. The reason is because the intensity of a magnetic field is in inverse proportion to 3 power of distance and because the first magnetic sensor is located near by the object to be inspected. In the above-mentioned example, the detectivity of the first magnetic sensor is approximately 450 times of the detectivity of the second magnetic sensor.

By the way, the spacing between the first magnetic sensor and the second magnetic sensor is not limited to 100 mm. Larger distance is preferred so long as other conditions allow, because the signal strength can be lifted. Now, when the spacing between the first magnetic sensor and the object to be inspected is "$X_1$" and the spacing between the second magnetic sensor and the object to be inspected is "$X_2$", following relationship of expression 1 between the output voltage S1 of the first magnetic sensor and the output voltage $S_2$ of the second magnetic sensor.

$$\text{Expression } 1 : S_1/S_2 = (X_1/X_2)^{-3}.$$

Accordingly, when there is a little varies of the output voltage between the magnetic sensors, the detecting equipment can detect a magnetic substance theoretically.

However, actually, it is preferred that the output voltage of one magnetic sensor is more than 2 times of the output voltage of the other magnetic sensor. When the spacing between the first magnetic sensor and the object to be inspected is 15 mm, the spacing of the second magnetic sensor and the object to be inspected meeting above-mentioned condition is 19 mm.. This value can be obtained from the expression 1.

Comparing

We compared the detecting equipments of the first embodiment and the second embodiment.

A copper wire having a diameter of 2.8 mm was prepared as an object to be inspected. Noise having random frequency was output from magnetic sensor at first. This noise was generated correspond to the traveling speed of the object to be inspected and effective detection could not completed. A possible cause is because a magnetic substance exists continually in the object to be inspected and the magnetic sensor detected it. It is thought that the magnetic substance exists in copper as solid solution.

Next, a band pass filter was inserted at the output of the signal processing circuit 5. The pass band of the filter was fitted to the peak frequency of noise correspond to the traveling speed of the wire. Condition of the measurement including the characteristic of the filter is shown in the following table.

Table

| | |
|---|---|
| Object to be inspected | Cu line |
| Speed of the Cu line | 40 m/minute |
| Cut-off frequency of the band pass filter | 20 Hz and 1 Hz |
| Attenuation slope of the filter | 42dB / oct. |

By use the equipment having the construction mentioned above, fine iron particle of 60 $\mu$m was able to be detected. S/N ratio of the detection was more than 5.

**Claims**

1. A detecting equipment adapted to inspect an object (1) that is a long material moving in the overall length direction and adapted to detect a magnetic minute substance contained in the object to be inspected, said detecting equipment comprises
   a magnetic field generation (2) means that generates a magnetic field having right angle to the traveling direction of the object to be inspected; and
   a magnetic sensor (3) that includes a SQUID for inspecting a drift of the magnetic field that is parallel to the magnetic field, **characterized in that**
   said magnetic sensor (3) includes a first magnetic sensor that is located nearby the object to be inspected and a second magnetic sensor that is located more at a greater distance to the object than the first magnetic sensor.

2. The detecting equipment according Claim 1 wherein said magnetic field generation means (2) and said magnetic sensor (3) is located along the path of said object (1) to be inspected successively.

3. The detecting equipment according Claim 1 wherein said magnetic sensor and a part of the object (1) to be inspected passing nearby the magnetic sensor (3) are surrounded by a magnetic shield container (4) defining a inspecting zone.

**4.** The detecting equipment according Claim 1 wherein the difference between the output of the first magnetic sensor and the output of the second magnetic sensor is treated as an output of the magnetic sensor.

**5.** The detecting equipment according Claim 1 wherein said second magnetic sensor is a SQUID (32) formed with an oxide superconducting thin film.

**6.** The detecting equipment according Claim 1 wherein said first magnetic sensor (3) is a flux transformer (31).

**7.** The detecting equipment according Claim 1 wherein said magnetic field generation means (2) comprises a permanent magnet (21) that is located nearby the object (1) to be inspected.

**8.** The detecting equipment according Claim 1 wherein said magnetic sensor (3) is adapted to output a signal through a band pass filter which has a characteristic according to traveling velocity of the object (1) to be inspected.

**Patentansprüche**

**1.** Erfassungseinrichtung, die angepasst ist, ein Objekt (1) zu untersuchen, das ein längliches Material ist, das sich in die Gesamtlängsrichtung bewegt, und die angepasst ist, eine magnetische Substanz in geringer Menge zu erfassen, die in dem zu untersuchenden Objekt enthalten ist, wobei die Erfassungseinrichtung umfasst:

- ein Mittel zum Erzeugen eines magnetischen Felds (2), das ein magnetisches Feld in einem rechten Winkel zur Bewegungsrichtung des zu untersuchenden Objekts erzeugt; und
- einen magnetischen Sensor (3), der einen SQUID einschließt, zum Untersuchen einer Verschiebung des magnetischen Feldes, das parallel zu dem magnetischen Feld ist, **dadurch gekennzeichnet, dass**
- der magnetische Sensor (3) einen ersten magnetischen Sensor, der nahe bei dem zu untersuchenden Objekt angeordnet ist, und einen zweiten magnetischen Sensor einschließt, der in einer größeren Entfernung zu dem Objekt angeordnet ist als der erste magnetische Sensor.

**2.** Erfassungseinrichtung gemäß Anspruch 1, wobei die Mittel zum Erzeugen eines magnetischen Felds (2) und der magnetischen Sensor (3) aufeinanderfolgend entlang des Pfads des zu untersuchenden Objekts (1) angeordnet sind.

**3.** Erfassungseinrichtung gemäß Anspruch 1, wobei der magnetische Sensor (3) und ein Teil des zu untersuchenden Objekts (1), das nahe an dem magnetischen Sensor (3) vorbeiläuft, von einem magnetischen Abschirmbehälter (4) umgeben sind, der die Untersuchungszone definiert.

**4.** Erfassungseinrichtung gemäß Anspruch 1, wobei der Unterschied zwischen der Ausgabe des ersten magnetischen Sensors und der Ausgabe des zweiten magnetischen Sensors als eine Ausgabe des magnetischen Sensors behandelt wird.

**5.** Erfassungseinrichtung gemäß Anspruch 1, wobei der zweite magnetische Sensor ein SQUID (32) ist, der mit einem oxidischen, supraleitenden, dünnen Film gebildet ist

**6.** Erfassungseinrichtung gemäß Anspruch 1, wobei der erste magnetische Sensor (3) ein Fluss-Wandler (31) ist.

**7.** Erfassungseinrichtung gemäß Anspruch 1, wobei das Mittel zum Erzeugen eines magnetischen Felds (2) einen Permanentmagneten (21) umfasst, der nahe bei dem zu untersuchenden Objekt (1) angeordnet ist.

**8.** Erfassungseinrichtung gemäß Anspruch 1, wobei der magnetische Sensor (3) angepasst ist, ein Signal durch einen Bandpassfilter auszugeben, der eine Charakteristik gemäß der Bewegungsgeschwindigkeit des zu untersuchenden Objekts (1) aufweist.

**Revendications**

**1.** Equipement de détection adapté à inspecter un objet (1) qui est un matériau long se déplaçant dans la direction de la longueur globale et adapté à détecter une substance magnétique minuscule contenue dans l'objet à inspecter, ledit équipement de détection comprenant :

un moyen de génération de champ magnétique (2) qui génère un champ magnétique perpendiculaire à la direction de déplacement de l'objet à inspecter ; et

un capteur magnétique (3) qui comprend un SQUID pour inspecter une dérive du champ magnétique qui est parallèle au champ magnétique, **caractérisé en ce que**

ledit capteur magnétique (3) comprend un premier capteur magnétique qui est situé à proximité de l'objet à inspecter et un second capteur magnétique qui est situé à une distance plus grande de l'objet que le premier capteur magnétique.

2. Equipement de détection selon la revendication 1 dans lequel ledit moyen de génération de champ magnétique (2) et ledit capteur magnétique (3) sont situés le long du trajet dudit objet (1) à inspecter de manière successive.

3. Equipement de détection selon la revendication 1 dans lequel ledit capteur magnétique et une partie de l'objet (1) à inspecter passant à côté du capteur magnétique (3) sont entourés par un conteneur de protection magnétique (4) définissant une zone d'inspection.

4. Equipement de détection selon la revendication 1 dans lequel la différence entre la sortie du premier capteur magnétique et la sortie du second capteur magnétique est traitée comme une sortie du capteur magnétique.

5. Equipement de détection selon la revendication 1 dans lequel ledit second capteur magnétique est un SQUID (32) formé avec un film fin super conducteur d'oxyde.

6. Equipement de détection selon la revendication 1 dans lequel ledit premier capteur magnétique (3) est un transformateur de flux (31).

7. Equipement de détection selon la revendication 1 dans lequel ledit moyen de génération de champ magnétique (2) comprend un aimant permanent (21) qui est situé à proximité de l'objet (1) à inspecter.

8. Equipement de détection selon la revendication 1 dans lequel ledit capteur magnétique (3) est adapté à émettre en sortie un signal à travers un filtre passe bande qui a une caractéristique selon la vitesse de déplacement de l'objet (1) à inspecter.

Fig. 1

3 MAGNETIC SENSOR

1 OBJECT TO BE
INSPECTED

2 MAGNETIC FIELD
GENERATION MEANS

EP 0 814 342 B1

## Fig. 2

4 MAGNETIC SHIELD CONTAINER

3 MAGNETIC SENSOR

2 MAGNETIC FIELD GENERATION MEANS

21 PERMANENT MAGNET

1 OBJECT TO BE INSPECTED

22 YOKE
21 PERMANENT MAGNET

5 SIGNAL PROCESSING CIRCUIT

6 PEN RECORDER

## Fig. 3

33 COOLING MEDIUM

32 SQUID

31 FLUX
TRANSFORMER

3 MAGNETIC
SENSOR

34 HEAT INSULATION
CONTAINER

31B
INPUT COIL

31A COIL PICKUP

## Fig. 4

1sec

12.5mV

60μm          100μm          180μm

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 08273433 B